# EUROPEAN PATENT SPECIFICATION

(11) **EP 0 914 028 B1**
(45) Date of publication and mention of the grant of the patent: **09.02.2005**
(21) Application number: 98308773.5
(22) Date of filing: 27.10.1998
(51) Int. Cl.: H05K 7/10, H01R 13/24, H01R 12/16

(54) **Interposer assembly**
Piéce d' interposition
Zwischenstück

(30) Priority: 30.10.1997 US 960953
(43) Date of publication of application: 06.05.1999
(60) Divisional application: 01104395.7
(73) Proprietor: Intercon Systems, Inc., Harrisburg, Pennsylvania 17110-9310 (US)
(72) Inventor: Neidich, Douglas A., Harrisburg, Pennsylvania 17331 (US); Walden, John D., Mechanicsburg, Pennsylvania 17055 (US)
(74) Representative: von Samson-Himmelstjerna, Friedrich R., Dipl.-Phys.

(56) References cited:
- EP-A- 0 742 682
- DE-A- 4 039 009
- US-A- 5 653 598

## Description

The invention relates to interposer assemblies used for forming electrical connections between contact pads on circuit members.

Interposer assemblies are used for forming electrical connections between densely spaced contact pads on adjacent parallel circuit members. The pads on the members are arranged in identical patterns. Commonly, the circuit members are a circuit board and a ceramic plate carrying integrated circuits. The interposer assembly includes an insulating plate and a plurality of through-contacts carried in the plate and arranged in the same pattern as the pads on the circuit members. The contacts project above the top and bottom of the plate. The assembly is sandwiched between the two members which are held together with the contacts forming electric connections between appropriate aligned pairs of pads.

Interposer assemblies are used for forming electrical connections between contact pads arranged in a very close proximity to each other. The pads may be arranged on a one millimeter center-to-center grid. In addition to requiring contacts which can be spaced very close to each other, the contacts must form reliable electrical connections with the pads when the assemblies are sandwiched between the circuit members. A low mechanical closure force is required in order to prevent undue stress to a ceramic circuit member. A high closure force could distort or possibly break the ceramic member. Further, interposer assemblies must occupy a minimum width space between the circuit members, requiring that the individual electrical contacts in the assembly have a limited height yet possess the required spring properties for establishing reliable electrical connections between the pads without undue closing force.

Conventional interposer assemblies use terminals which occupy a relatively large amount of space in the supporting plate making it difficult to meet closely spaced grid requirements. These assemblies are relatively expensive to manufacture and assemble.

EP-A-0 742 682 discloses a socket for a packaged integrated circuit having a plurality of contact holes and spring contact elements. This socket includes a molded protrusion extending into each of the holes.

US-A-5,653,598 discloses a connector body having a plurality of contact cavities without protrusions and using contact bodies with spring arms.

The invention is an improved interposer assembly including metal contacts loosely confined in closely spaced passages extending through an insulating plate. The contacts include arcuate spring portions which are elastically bent to form wiped connections with the pads and reduce the force necessary to sandwich the interposer assembly between the circuit members. The low closure force reduces the risk of damage to an overlying ceramic substrate and allows a large number of contacts in the assembly. The wiped electrical connections between the contacts and the circuit pads form reliable electrical connections between the adjacent pairs of pads and permit installation of the interposer assemblies in user's facilities. The assemblies need not be installed in clean rooms.

The disclosed interposer assembly uses plates and integral metal contacts which are easily and inexpensively manufactured and assembled. The plate is a one-piece design and includes through passages with contact retention projections extending into the passages. The projections are having opposed retention surfaces. The contacts are generally D-shaped and are readily inserted into the passages to snap or latch over the projections, which then hold the contacts loosely in place in the passages prior to sandwiching of the assemblies between circuit members. The free ends of each contact are then located on opposite sides of a projection and are spaced apart a distance greater than the distance between the retention surfaces of the projection to permit free limited movement of each contact along a passage. The contacts are compact, permitting use of the assembly to form electrical connections between very closely spaced contact pads.

Other objects and features of the invention will become apparent as the description proceeds, especially when taken in conjunction with the accompanying drawings illustrating the invention, of which there are three sheets and one embodiment.
Figure 1 is a top view of an interposer assembly per the invention;
Figure 2 is a sectional view taken along line 2--2 of Figure 1;
Figure 3 is a sectional view illustrating the position of the assembly between two circuit members;
Figure 4 is a view like Figure 3 showing the assembly sandwiched between the circuit members;
Figure 5 is a perspective view of a contact used in the assembly; and
Figure 6 is a sectional view illustrating insertion of the contact member into a passage through the plate.

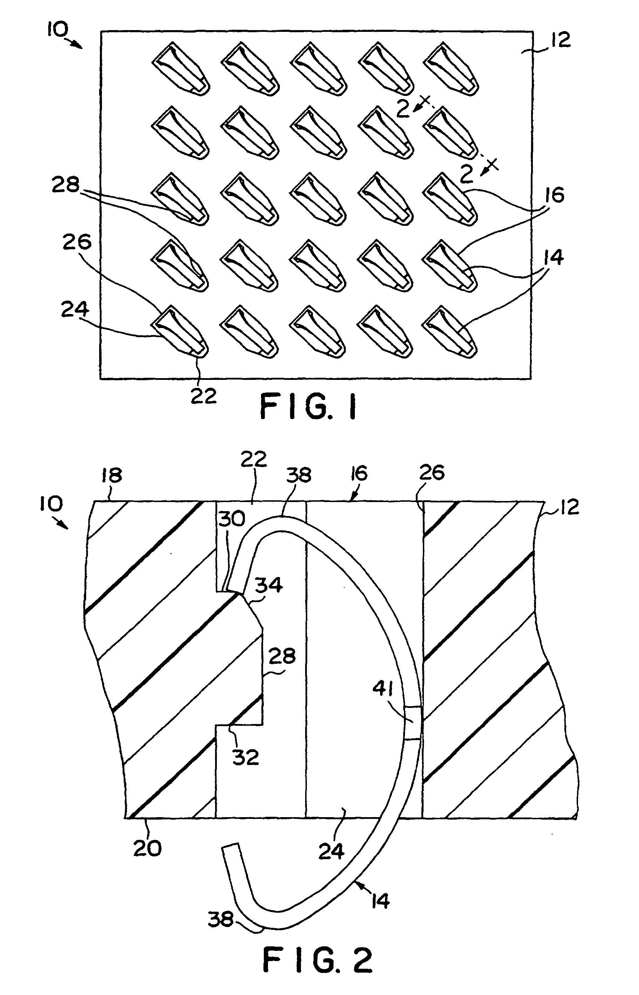

Interposer assembly 10 includes a flat plate 12 formed of insulating material with a plurality of metal contacts 14 positioned in passages 16 extending through the thickness of the plate between opposed plate top and bottom surfaces 18 and 20. As shown in Figure 1, passages 16 are each provided with a reduced width side 22 and a uniform width portion 24 away from side 22. Flat side wall 26 extends across the uniform width portions 24 opposite the reduced width side 22.

Contact retention projections are provided in the reduced width sides 22 of passages 16. Projections 28 extend a distance into the passages and include contact retention surfaces 30 and 32 facing plate top and bottom 18 and 20, respectively. The surfaces 30 and 32 are spaced in from the top and bottom of the plate. A sloped cam surface 34 extends from each retention surface 30 to the inner end of the projection 28 and faces top 18. Surface 34 facilitates insertion of contact 14 into passage 16.

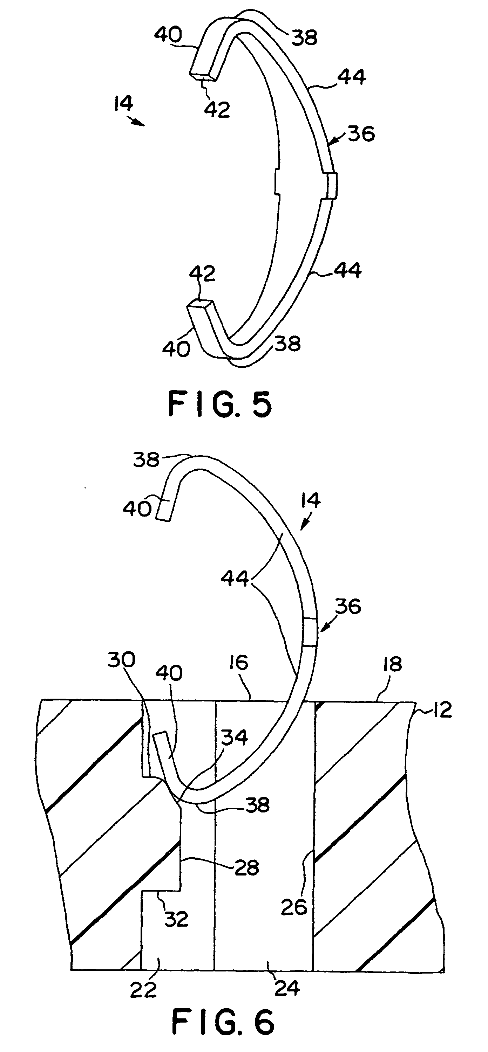

Each metal contact 14 is preferably formed from uniform thickness strip stock, which may be suitably plated beryllium copper. The contact is generally D-shaped and includes a arcuate, convex spring 36 with a pair of opposed contact noses 38 at the ends of the springs. The noses are spaced apart a distance greater than the thickness of the plate 12. Short retention legs 40 extend inwardly from the noses to free ends 42. The legs 40 extend away from spring 36 so that the noses 38 are located between the free ends 42 and the spring. As illustrated in Figure 5, spring 36 has a maximum width midway between noses 38 and includes two tapered width spring portions or arms 44 each extending from the center of the spring to a nose 38, in order to reduce stress concentration when the spring is stressed.

Contacts 14 are inserted into passages 16 as shown in Figure 6. One nose of the contact is extended into the end of the passage opening at plate top 18 and is positioned between the projection 28 and end wall 26. The contact is inserted into the passage and leg 40 is guided by surface 34 to the end of the projection and spring 36 engages wall 26. The contact is then inserted further into the passage with the result that the lower spring arm 44 is elastically stressed, leg 40 is moved past projection 28 and snaps back under retention surface 32. With the contact inserted in passage 16 end 42 of the upper retention leg 40 is above the upper retention surface 30, end 42 of the lower retention leg 40 is located below the lower retention surface 32 and the center 41 of the arcuate spring is adjacent the flat end wall 26. Spring 36 is bowed toward wall 26. The contact is loosely held in the passage between side 22 and side wall 26. The distance between the free ends 42 of legs 40 isgreater than the length of projection 28, permitting limited free movement of the contact in passage 16. Figure 2 illustrates the position of the contact in the passage when plate 12 is horizontal and the loose contact 14 is supported in the cavity against gravity with the end of the upper leg 40 resting on upper retention surface 30 of projection 28.

As illustrated in Figure 1, the passages 16 are arranged close to each other in a dense array on plate 12 in order to permit forming of electrical connections between similar arrays of contact pads on circuit elements located above and below the assembly. Conventionally, assembly 10 is used for forming electrical connections between contact pads on a ceramic integrated circuit and contact pads of a circuit board. The assembly may be used for forming electrical connections between contact pads on two circuit boards or between contact pads on other types of circuit members.

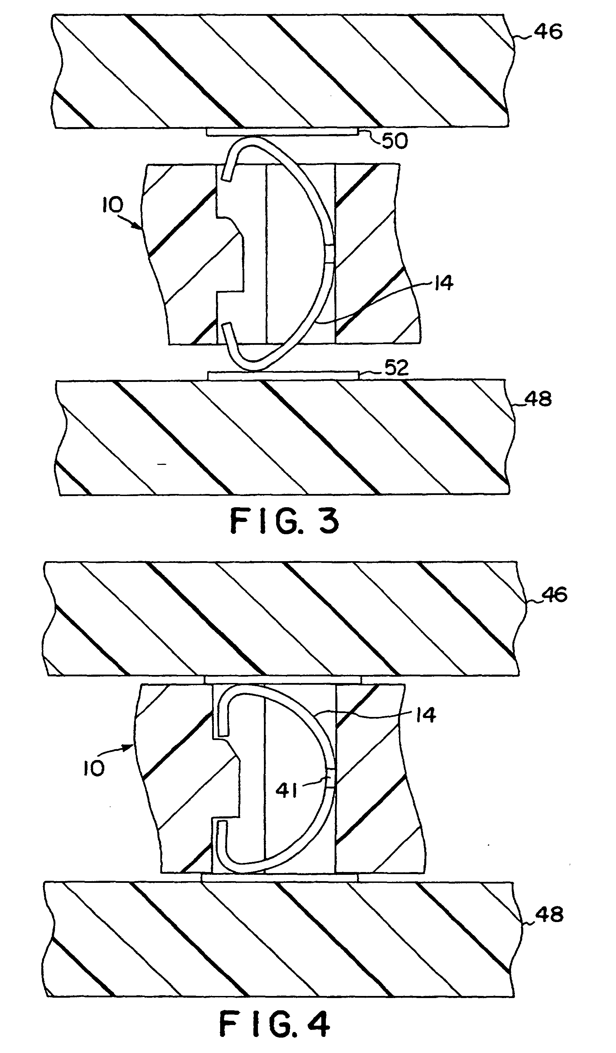

Figure 3 illustrates the interposer assembly 10 positioned between upper and lower circuit members 46 and 48 with contact, pads 50 and 52 on the members located above and below each contact in the assembly. The contacts lightly engage the pads and are not stressed.

Figure 4 illustrates the assembly 10 when fully sandwiched between member 46 and 48 with the members held tightly against the assembly plate 12. When the members are brought into contact with the assembly 10 the two contact pads 50 and 52 are moved together to reduce the height of contacts 14 and elastically bend the two tapered spring arms 44 of arcuate spring 36. The center of the spring engages the side wall 26 as shown in Figure 4. Bending of the arcuate spring and foreshortening of the contact moves or wipes the contact noses 38 a distance along the contact pads toward side 22 to make clean, low resistance pressure electrical connections between the contact noses 38 and the pads 50 and 52. The connections assure that the contact 14 provides a reliable, low resistance electrical path between the pads.

As illustrated in Figure 4, foreshortening of contact 14 moves the free ends 42 of retention legs 40 together and brings the ends in close proximity to the retention surfaces 30 and 32 of projection 28. The retention legs do not engage the projection. Contact pressure is maintained by elastic bending of the spring 36 without bottoming of the ends of the contact on the projection or the walls of passage 16 which could undesirably increase the closing force.

## Claims

1. An interposer assembly comprising an insulating plate (12) having a plurality of passages (16) extending through the thickness of the plate and a projection (28) extending into each passage (16); and a plurality of integral metal contacts (14) each including a convex spring (36), contact noses (38) at the ends of the spring and free ends (42) located closer together than the noses (38), said noses spaced apart a distance greater than the thickness of the plate (12), said assembly **characterized by** each projection (28) having opposed retention surfaces (30,32) and each contact being loosely confined in a passage (16) with the free ends (42) of each contact being located on opposite sides of a projection and being spaced apart a distance greater than the distance between the retention surfaces (30,32) of the projection to permit free limited movement of each contact along a passage.

2. An interposer assembly as in claim 1 wherein each contact includes a retention leg (40) extending from each contact nose to a free end.

3. An assembly as in either of claims 1 or 2 wherein in each contact the noses (38) are located between the free ends (42) and the center of the spring (36).

4. An assembly as in any preceding claim wherein each projection (28) includes a cam surface (34).

5. An assembly as in any preceding claim wherein each spring includes a central portion and a pair of tapered spring arms (44) extending in opposite directions away from the central portion.

6. An assembly as in claim 5 wherein each passage includes a first wall (26) away from the projection (28), and the central portion (41) of each spring is adjacent a first wall.

7. An assembly as in claim 6 including a pair of circuit members (46,48), one circuit member located on a top surface (18) of said insulating plate (12) and the other circuit member (48) located on a bottom surface (20) of said insulating plate (12), each circuit member (46,48), including contact pads (50,52) overlying the ends of the passages (16) and engaging the noses (38) at the ends of the spring arms, each spring bowed toward and engaging the passage wall (26), and including wiped pressure electrical connections between said noses and said pads (50,52).

8. An assembly as in claim 6 wherein each passage includes a second wall (22) spaced across the passage from the first wall; and each contact has a transverse dimension between the center of the contact and the free ends of the contact less than the spacing between the first and second walls.

9. An assembly as in any preceding claim wherein the width of each passage is reduced at the projection (28).

10. An assembly as in any preceding claim wherein each contact (14) is generally D-shaped.

11. An assembly as in any preceding claim wherein each contact (14) is formed from uniform thickness strip stock having opposed sides with the contact noses (38) forming curved portions of the strip stock and both lying on the same side of the contacts.

12. An assembly as in any preceding claim wherein each contact (14) is basically symmetrical to either side of a central portion (41) of the convex spring.

## Patentansprüche

1. Zwischenschaltungs-Baugruppe mit einer isolierenden Platte (12), die eine Anzahl von sich durch die Dicke der Platte erstreckenden Durchgängen (16) und einen sich in jeden Durchgang (16) erstreckenden Vorsprung (28) aufweist; und mit einer Anzahl von einstückigen Metallkontakten (14), die jeweils eine konvexe Feder (36), Kontaktnasen (38) an den Enden der Feder und näher beieinander als die Nasen (38) befindliche freie Enden (42) enthalten, wobei die Nasen um eine größere Entfernung als die Dicke der Platte (12) voneinander beabstandet sind, wobei die Baugruppe **dadurch gekennzeichnet ist, daß** jeder Vorsprung (28) entgegengesetzte Halteflächen (30, 32) aufweist und jeder Kontakt lose in einem Durchgang (16) gefangen ist, wobei die freien Enden (42) von jedem Kontakt an entgegengesetzten Seiten eines Vorsprungs befindlich und voneinander beabstandet sind um eine Entfernung, die größer ist als die Entfernung zwischen den Halteflächen (30, 32) des Vorsprungs, um eine freie begrenzte Bewegung jedes Kontakts längs eines Durchgangs zu gestatten.

2. Zwischenschaltungs-Baugruppe nach Anspruch 1, wobei jeder Kontakt einen Halteschenkel (40) enthält, der sich von jeder Kontaktnase zu einem freien Ende erstreckt.

3. Baugruppe nach einem der Ansprüche 1 oder 2, wobei bei jedem Kontakt die Nasen (38) zwischen den freien Enden (42) und der Mitte der Feder (36) befindlich sind.

4. Baugruppe nach einem der vorhergehenden Ansprüche, wobei jeder Vorsprung (28) eine Nockenfläche (34) enthält.

5. Baugruppe nach einem der vorhergehenden Ansprüche, wobei jede Feder einen Mittelbereich und ein Paar von sich verjüngenden, sich in entgegengesetzte Richtungen weg von dem Mittelbereich erstreckenden Federarmen (44) enthält.

6. Baugruppe nach Anspruch 5, wobei jeder Durchgang eine erste Wand (26) abseits von dem Vorsprung (28) enthält, und der Mittelbereich (41) jeder Feder an eine erste Wand anliegt.

7. Baugruppe nach Anspruch 6, enthaltend ein Paar von Schaltungselementen (46, 48), wobei ein Schaltungselement an einer oberen Fläche (18) der isolierenden Platte (12) befindlich ist und das andere Schaltungselement (48) an einer Bodenfläche (20) der isolierenden Platte (12) befindlich ist, wobei jedes Schaltungselement (46, 48) über den Enden der Durchgänge (16) liegende und an den Nasen (38) an den Enden der Federarme anliegende Kontaktanschlußflächen (50, 52) enthält, wobei jede Feder in Richtung zu der Durchgangswand (26) gebogen ist und an dieser anliegt, und mit einer Schleifbewegung unterworfenen elektrischen Verbindungen zwischen den Nasen und den Anschlußflächen (50, 52).

8. Baugruppe nach Anspruch 6, wobei jeder Durchgang eine zweite Wand (22) enthält, die quer zu dem Durchgang von der ersten Wand beabstandet ist; und wobei jeder Kontakt eine Querabmessung zwischen der Mitte des Kontakts und den freien Enden des Kontakts hat, die kleiner ist als der Abstand zwischen den ersten und zweiten Wänden.

9. Baugruppe nach einem der vorhergehenden Ansprüche, wobei die Breite eines jeden Durchgangs an dem Vorsprung (28) vermindert ist.

10. Baugruppe nach einem der vorhergehenden Ansprüche, wobei jeder Kontakt (14) allgemein D-förmig ist.

11. Baugruppe nach einem der vorhergehenden Ansprüche, wobei jeder Kontakt (14) aus gegenüberliegende Seiten aufweisendem Streifenmaterial gleichförmiger Dicke gebildet ist, wobei die Kontaktnasen (38) gekrümmte Bereiche des Streifenmaterials bilden und beide auf der selben Seite der Kontakte liegen.

12. Baugruppe nach einem der vorhergehenden Ansprüche, wobei jeder Kontakt (14) grundsätzlich symmetrisch ist zu jeder Seite eines Mittelbereichs (41) der konvexen Feder.

## Revendications

1. Pièce d'interposition, comprenant une plaque isolante (12), comprenant une pluralité de passages (16), s'étendant à travers l'épaisseur de la plaque, et une saillie (28), s'étendant dans chaque passage (16), et une pluralité de contacts métalliques (14) monolithiques, chacun comprenant un ressort (36) convexe, des ergots de contact (38) aux extrémités du ressort et des extrémités libres (42) placées conjointement plus près que les ergots (38), lesdits ergots étant espacés entre eux d'une distance supérieure à l'épaisseur de la plaque (12), ladite pièce étant **caractérisée par le fait que** chaque saillie (28) présente des surfaces de retenue (30, 32) opposées et chaque contact étant confiné de façon lâche dans un passage (16), les extrémités libres (42) de chaque contact étant placées sur des côtés opposés d'une saillie et étant espacées les unes des autres d'une distance supérieure à la distance existant entre les surfaces de retenue (30, 32) de la saillie, afin de permettre un déplacement libre limité de chaque contact le long d'un passage.

2. Une pièce d'interposition selon la revendication 1, dans laquelle chaque contact comprend une patte de retenue (40), s'étendant depuis chaque ergot de contact vers une extrémité libre.

3. Pièce selon la revendication 1 ou 2, dans laquelle, dans chaque contact, les ergots (38) sont placés entre les extrémités libres (42) et le centre du ressort (36).

4. Pièce selon l'une quelconque des revendications précédentes, dans laquelle chaque saillie (28) comprend une surface de came (34).

5. Pièce selon l'une quelconque des revendications précédentes, dans laquelle chaque ressort comprend une partie centrale et une paire de bras élastiques (44) effilés, s'étendant dans des directions opposées en s'écartant de la partie centrale.

6. Pièce selon la revendication 5, dans laquelle chaque passage comprend une première paroi (26) écartée de la saillie (28), et la partie centrale (41) de chaque ressort étant adjacente à une première paroi.

7. Pièce selon la revendication 6, comprenant une paire d'organes de circuit (46, 48), un organe de circuit étant placé sur une surface supérieure (18) de ladite plaque isolante (12) et l'autre organe de circuit (48) étant placé sur une surface inférieure (20) de ladite plaque isolante (12), ledit organe de circuit (46, 48) comprenant des plages de connexion par contact (50, 52), recouvrant les extrémités des passages (16) et venant en prise avec les ergots (38) aux extrémités des bras élastiques, chaque ressort étant arqué en direction de, et venant en prise avec, la paroi de passage (26), et comprenant des connexions électriques sous pression avec balai, entre lesdits ergots et lesdites plages de connexion (50, 52).

8. Pièce selon la revendication 6, dans laquelle chaque passage comprend une deuxième paroi (22) espacée, disposée dans le passage depuis la première paroi ; et chaque contact présente, entre le centre de contact et les extrémités libres du contact, une dimension transversale inférieure à l'espacement que l'on a entre les première et deuxième parois.

9. Pièce selon l'une quelconque des revendications précédentes, dans laquelle la largeur de chaque passage est réduite au niveau de la saillie (28).

10. Pièce selon l'une quelconque des revendications précédentes, dans laquelle chaque contact (14) est globalement en forme de D.

11. Pièce selon l'une quelconque des revendications précédentes, dans laquelle chaque contact (14) est formé à partir d'un matériau en forme de bande, d'épaisseur uniforme, ayant des côtés opposés, les ergots de contact (38) formant des parties incurvées du matériau en forme de bande, et tous deux étant situés du même côté des contacts.

12. Pièce selon l'une quelconque des revendications précédentes, dans laquelle chaque contact (14) est fondamentalement symétrique de chaque côté d'une partie centrale (41) du ressort convexe.
